(19) Europäisches Patentamt
European Patent Office
Office européen des brevets

(11) Veröffentlichungsnummer: **0 262 629 B1**

# (12) EUROPÄISCHE PATENTSCHRIFT

(45) Veröffentlichungstag der Patentschrift: **17.04.91**

(51) Int. Cl.5: **G03F 7/027**, G03F 7/029, G03F 7/032

(21) Anmeldenummer: **87114096.8**

(22) Anmeldetag: **26.09.87**

## (54) Photopolymerisierbare Aufzeichnungsmasse, insbesondere zur Herstellung von Druckplatten und Reliefformen.

(30) Priorität: **01.10.86 DE 3633436**

(43) Veröffentlichungstag der Anmeldung:
**06.04.88 Patentblatt 88/14**

(45) Bekanntmachung des Hinweises auf die Patenterteilung:
**17.04.91 Patentblatt 91/16**

(84) Benannte Vertragsstaaten:
**AT BE CH DE ES FR GB IT LI**

(56) Entgegenhaltungen:
**DE-A- 3 443 221**
**US-A- 4 385 109**
**US-A- 4 737 593**

(73) Patentinhaber: **BASF Aktiengesellschaft**
**Carl-Bosch-Strasse 38**
**W-6700 Ludwigshafen(DE)**

(72) Erfinder: **Boettcher, Andreas, Dr.**
**Breslauer Strasse 24**
**W-6906 Leimen(DE)**
Erfinder: **Bronstert, Bernd, Dr.**
**Zanderstrasse 35**
**W-6701 Otterstadt(DE)**
Erfinder: **Hoffmann, Gerhard, Dr.**
**Pappelstrasse 22**
**W-6701 Otterstadt(DE)**

**EP 0 262 629 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft verbesserte photopolymerisierbare Aufzeichnungsmassen, die wäßrig oder wäßrig alkalisch entwickelbar sind und überwiegend aus einer Photoinitiator enthaltenden Mischung von a) mindestens einer niedermolekularen Verbindung mit mindestens einer photopolymerisierbaren olefinisch ungesättigten Doppelbindung und b) mindestens einem organischen polymeren Bindemittel bestehen, die eine Bisacylphosphinoxid-verbindung als Photoinitiator enthalten.

Photopolymerisierbare Aufzeichnungsmassen, wie sie für die Herstellung von Druckplatten und Reliefformen verwendet werden, sind vielfach beschrieben worden und umfassen sowohl flüssige als auch feste Massen. Beispielsweise sind derartige Aufzeichnungsmassen in der DE-OS 20 40 390 oder FR-PS 15 20 856 beschrieben. Als Photoinitiatoren für die Aufzeichnungsmassen werden hauptsächlich aromatische Ketone wie Benzilketale, Benzoinether oder $\alpha$-Methylol-Derivate von Benzoinethern verwendet. Obgleich diese Initiatorsysteme zu brauchbaren Ergebnissen führen, verlangen die modernen Methoden der Aufzeichnungstechnik, insbesondere im Zeitungsdruck immer kürzere Belichtungszeiten, die unter Verwendung der herkömmlichen Photoinitiatorsysteme nicht befriedigend erfüllt werden können. So sind die umweltfreundlichen wasserauswaschbaren Druckplatten bislang noch so raktionsträge, daß durch den Kunstgriff der Vorbelichtung für eine ausreichende Sensibilisierung gesorgt werden muß. Neben anderen Nachteilen bedeutet dies jedoch einen zusätzlichen Arbeitsgang.

Bei den Aufzeichnungsmassen mit den herkömmlichen Initiatorsystemen wird häufig auch die Reliefstruktur ungünstig ausgebildet und muß durch besondere Maßnahmen, wie Zusätze photochromer Verbindungen, Steuerung der Lichtreflexion am Trägerblech oder durch Zusatz besonderer Inhibitoren, die aber die Belichtungszeit verlängern, verbessert werden.

Eine wesentliche Verbesserung wurde durch den Einsatz von Acylphosphinoxid-Verbindungen als Photoinitiatoren (EP 00 59 988) erreicht.

In der DE-A-34 43 221 werden Bisacylphosphinoxide, ihre Herstellung und Verwendung als Photoinitiatoren in photopolymerisierbaren Massen, wie z.B. für Zahnfüllmassen, beschrieben, wobei auch mögliche Zusätze gesättigter und/oder ungesättigter Polymerer erwähnt werden.

Der vorliegende Erfindung lag die Aufgabe zugrunde, einfacher handhabbare Aufzeichnungsmassen aufzuzeigen, die bereits ohne Vorbelichtung eine noch kürzere Gesamtbelichtungszeit ermöglichen und für den Fall, daß sich eine Vorbelichtung als zweckmäßig erweist, der Vorbelichtungsgrad genauer eingestellt werden kann.

Es wurde nun überraschend gefunden, daS dies durch Verwendung bestimmter Bisacylphosphinoxide ermöglicht wird.

Gegenstand der Erfindung sind somit photopolymerisierbare Aufzeichnungsmassen, die wäßrig oder wäßrig alkalisch entwickelbar sind. Sie sind insbesondere für die Herstellung von Druckplatten und Reliefformen geeignet, bestehen aus einer einen Photoinitiator enthaltenden Mischung a) mindestens einer niedermolekularen Verbindung mit mindestens einer photopolymerisierbaren olefinisch ungesättigten Doppelbindung und b) mindestens einem organischen polymeren Bindemittel, und sind dadurch gekennzeichnet, daß sie als Photoinitiator Bisacylphosphinoxid-Verbindungen der Formel

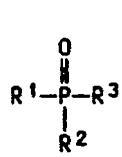

(I),

wobei $R^1$ für einen Alkylrest mit 1 bis 6 Kohlenstoffatomen, einen Cycloalkylrest mit 5 oder 6 Ringkohlenstoffatomen, einen Alkoxyrest mit 1 bis 4 C-Atomen, einen gegebenenfalls halogen-, alkyl- oder alkoxysubstituierten Arylrest oder einen S- oder N-haltigen fünf- oder sechsgliedrigen heterocyclischen Rest steht; $R^2$ und $R^3$ untereinander gleiche oder verschiedene Acylreste sind, an deren Carbonylgruppe ein tertiärer Alkylrest mit 4 bis 18 C-Atomen, ein tertiärer Cycloalkylrest mit 5 oder 6 Ringkohlenstoffatomen, ein Arylrest oder ein 5- oder 6-gliedriger heterocyclischer Rest gebunden ist, wobei die Aryl- oder 5- oder 6-gliedrigen heterocyclischen Reste mindestens in den beiden ortho-Stellungen zur Carbonylgruppierung Substituenten A und B gebunden enthalten, wobei A und B Alkyl-, Alkoxy-, Alkoxyalkyl-, Alkylthio-, Cycloakyl- oder Arylreste oder Halogenatome sind und A und B gleich oder verschieden sein können, und als organisches Bindemittel (b) mindestens ein wäßrig oder wäßrig-alkalisch auswaschbares Bindemittel aus der Gruppe der Cellulosederivate, der Polymeren mit wiederkehrenden Vinylalkoholgruppen in der Molekülhauptkette, der Polyurethane, Polyetherurethane, Polyesterurethane, der Polyester linearer oder verzweigter Natur und der Acrylatkautschuke mit seitenständigen Carboxylgruppen enthalten.

Das Merkmal "in den beiden ortho-Stellungen zur Carbonylgruppierung Substituenten A und B gebunden enthält", ist hier so zu verstehen, daß die Substituenten A und B in den beiden zur Verknüpfungsstelle mit der Carbonylgruppe benachbarten Ringkohlenstoffatomen, die substituiert sein können, gebunden sind. Dies bedeutet, daß der α-Naphthylrest mindestens in der 2,8-Stellung und der β-Naphthylrest mindestens in der 1,3-Stellung die Substituenten A und B gebunden enthält.

Bezüglich der Formel (1) ist im einzelnen folgendes auszuführen: $R^1$ kann sein ein geradkettiger oder verzweigter Alkylrest mit 1 bis 6 C-Atomen, wie Methyl, Ethyl, 1-Propyl, n-Propyl, n-Butyl, Amyl oder n-Hexyl, ein Cyclopentyl- oder Cyclohexylrest, einen Alkoxyrest mit 1 bis 4 C-Atomen, ein Arylrest, wie Phenyl oder Naphthyl, ein halogensubstituierter Arylrest wie Mono- oder Dichlorphenyl, ein alkylsubstituierter Arylrest, wie Methylphenyl, Ethylphenyl, Isopropylphenyl, tert.-Butylphenyl oder Dimethylphenyl, ein alkoxysubstiuierter Arylrest, wie Methoxyphenyl, Ethoxyphenyl, Dimethoxyphenyl, ein S- oder N-haltiger fünf- oder sechsgliedriger heterocyclischer Rest, wie Thiophenyl oder Pyridyl; $R^2$ und $R^3$ können untereinander gleiche oder verschiedene Acylreste, vorzugsweise gleiche Acylreste sein.

An die Carbonylgruppe der Acylreste $R^2$ und $R^3$ kann z.B. gebunden sein ein Phenyl- oder Naphthylrest, ein fünf- oder sechsgliedriger heterocyclischer Rest mit insbesondere S-, N- oder O-Ringatomen im Heterocyclus, z.B. ein Furyl-, Pyrrolyl-, Thienyl-, Pyranyl- oder Pyridylrest, der zumindest in den beiden ortho-Stellungen zur Carbonylgruppe die Substituenten A und B gebunden enthält. Geeignete Substituenten A und B sind gegebenenfalls verzweigte Alkylreste mit insbesondere 1 bis 6, vorzugsweise 1 bis 4 Kohlenstoffatomen, wie Methyl, Ethyl, Propyl, iso-Propyl, Butyl, iso-Butyl und tert.-Butyl; gegebenenfalls substituierte Cycloalkylreste, wie Cyclohexyl, gegebenenfalls substituierte Arylreste, z.B. Phenyl oder Toluyl, Alkoxy- oder Alkylthioreste mit insbesondere 1 bis 6, vorzugsweise 1 bis 4 Kohlenstoffatomen, wie Methoxy, Ethoxy, Propoxy, iso-Propoxy, n-Butoxy, Methylthio, Ethylthio, Propylthio, iso-Propylthio, n-Butylthio, sec.-Butylthio und tert.-Butylthio; Alkoxyalkylreste mit insbesondere 2 bis 12, vorzugsweise 2 bis 8 Kohlenstoffatomen, wie 2-Methoxyethyl oder tert.-Butoxy-2-propyl; Halogenatome, wie insbesondere Chlor- oder Bromatome.

Bevorzugte Substituenten A und B sind Halogenatome, insbesondere Chlor sowie Alkoxy-, wie z.B. Methoxy-, sowie Alkylgruppen, wie z.B. Methyl und Ethyl.

$R^2$ und $R^3$ können aber auch tertiäre Alkyl- oder Cycloalkylreste (mit jeweils einem tertiären C-Atom in Nachbarstellung zur Carbonylgruppe) sein, wie tert.Butyl, 1,1-Dimethylheptyl, 1-Methylcyclohexyl oder 1-Methylcyclopentyl.

Bisacylphosphinoxide, ihre Herstellung und Verwendung in photopolymerisierbaren Dentalmassen sind aus der EP-A-01 84 095 bekannt. Demgegenüber sind die bei Verwendung von Bisacylphosphinoxiden in wäßrig oder wäßrig-alkalisch entwickelbaren photopolymerisierbaren Aufzeichnungsmassen erzielten Effekte, insbesondere die erzielte verbesserte Handhabbarkeit zweifellos überraschend.

Die Herstellung von Bisacylphosphinoxid-Verbindungen kann beispielsweise in Analogie zu den in DE-A-34 43 221 angegebenen Verfahren erfolgen.

Sehr geeignet sind Aufzeichnungsmassen, die Bisacylphosphinoxid-Verbindungen der Formel I enthalten wobei $R^1$ = Aryl mit 6 bis 12 C-Atomen wie Naphthyl, Toluyl und insbesondere Phenyl, $C_1$-$C_4$-Alkoxy wie Methoxy oder Ethoxy und insbesondere Aryl mit 6 bis 12 C-Atomen darstellt.

Als Beispiele geeigneter Bisacylphosphinoxide der Formel I für die erfindungsgemäßen Aufzeichnungsmassen seien genannt:

Bis(2,6-dichlorbenzoyl)-phenylphosphinoxid,
Bis(2,6-dichlorbenzoyl)-2,5-dimethylphenylphosphinoxid,
Bis(2,6-dichlorbenzoyl)-4-ethoxyphenylphosphinoxid,
Bis(2,6-dichlorbenzoyl)-4-chlor-phenyl-phosphinoxid,
Bis(2,6-dichlorbenzoyl)-4-propyl-phenyl-phosphinoxid,
Bis(2,6-dichlorbenzoyl)-4-biphenylyl-phosphinoxid,
Bis(2,6-dimethoxybenzoyl)-2,5-dimethylphenylphosphinoxid,
Bis(2,6-dimethoxybenzoyl)-phenylphosphinoxid,
Bis(2,6-dichlor-3,4,5-trimethoxybenzoyl)-2,5-dimethylphenylphosphinoxid,
Bis(2-methyl-1-naphthoyl)-phenylphosphinoxid,
Bis(2-methyl-1-naphthoyl)-4-bisphenylyl-phosphinoxid,
Bis(2-methoxy-1-naphthoyl)2,5-dimethylphenylphosphinoxid,
Bis(2-methoxy-1-naphthoyl)-4-ethoxyphenylphosphinoxid.

Die erfindungsgemäßen Aufzeichnungsmassen können die Bisacylphosphinoxide der Formel I als alleinige Photoinitiatoren enthalten, im allgemeinen in einer Menge von 0,005 bis 10 und insbesondere in einer Menge von 0,05 bis 5 Gew.%, bezogen auf die Gesamtmenge der photopolymerisierbaren Aufzeichnungsmasse, doch können die Bisacylphosphinoxid-Verbindungen auch in Kombination mit bekannten Photoinitiatoren in den photopolymerisierbaren Aufzeichnungsmassen verwendet werden. Als Beispiele geeigneter bekannter Photoinitiatoren seien die des Ketontyps genannt, wie Benzildimethylketal, α-Hydroxyisobutyrophenon oder Diethoxyacetophenon sowie α-Methylolbenzoinethylether, Benzoinmethylether oder Benzoinisopropylether.

Es ist oft von Vorteil, in den Aufzeichnungsmassen die Bisacylphosphinoxide der Formel I in Kombination mit tert.Aminen wie Methyldiethanolamin, Dimethylethanolamin, Triethanolamin, p-Dimethylaminobenzoesäureethylester oder p,p'-Dialkylamino-substituierte Benzophenone, wie z.B. Michler's Keton zu verwenden. Die Gesamtkonzentration an Initiatorsystem (Photoinitiatoren plus Amine) liegt dabei zwischen 0,05 und 15 Gew.%, bezogen auf die Gesamtmenge der photopolymerisierbaren Aufzeichnungsmasse, wobei der Aminanteil vorzugsweise mindestens gleich der Hälfte des Gesamtinitiatorgehalts ist.

Für die Mischung aus a) und b), die die Basis für die erfindungsgemäßen Aufzeichnungsmassen darstellt, sind als niedermolekulare Verbindungen mit mindestens einer photopolymerisierbaren olefinisch ungesättigten Doppelbindung die für solche Massen bekannterweise verwendeten Monomeren geeignet, soweit sie mit den jeweils gewählten polymeren Bindemitteln verträgliche Mischungen bilden und einen Siedepunkt von über 100 °C bei Atmosphärendruck haben. Sie können beispielsweise ein Molekulargewicht unter 2000 und insbesondere unter 1000 haben. Bevorzugt sind Monomere mit zwei oder mehr olefinisch ungesättigten photopolymrisierbaren Doppelbindungen allein oder deren Mischungen mit Monomeren mit nur einer olefinisch ungesättigten photopolymerisierbaren Doppelbindung, wobei dann der Anteil der Monomeren mit nur einer Doppelbindung im allgemeinen nur etwa 5 bis 50 und bevorzugt 5 bis 30 Gew.% der Gesamtmonomerenmenge beträgt. Die Art der verwendeten Monomeren richtet sich weitgehend nach der Art des mitverwendeten polymeren Bindemittels. Beispielsweise eignen sich di- und polyfunktionelle Acrylate und Methacrylate, wie sie durch Veresterung von Diolen oder Polyolen mit Acrylsäure oder Methacrylsäure hergestellt werden können, wie die Di- bzw. Tri(meth)acrylate von Ethylenglykol, Diethylenglykol, Triethylenglykol, Polyethylenglykol mit einem Molekulargewicht bis etwa 500, 1,2-Propandiol, 1,3-Propandiol, Neopentylglykol, (2,2-Dimethylpropandiol), 1,4-Butandiol, 1,1,1-Trimethylolpropan, Glycerin oder Pentaerythrit, ferner die Monoacrylate und Monomethacrylate solcher Diole und Polyole, wie z.B. Ethylenglykol- oder Di-, Tri- oder Tetraethylenglykol-monoacrylat, Monomere mit zwei- oder mehr olefinisch ungesättigten Bindungen, die Urethangruppen und/oder Amidgruppen enthalten, wie die aus aliphatischen Diolen der vorstehend genannten Art, organischen Diisocyanaten und Hydroxyalkyl(meth)acrylaten hergestellten niedermolekularen Verbindungen sowie Umsetzungsprodukte von Mono-, Di oder Polyepoxidverbindungen mit Acrylsäure, Methacrylsäure oder Hydroxyalkyl(meth)acrylamiden oder Umsetzungsprodukte aus Glycidyl(meth)acrylaten mit Alkoholenoder mehrwertigen Alkoholen der oben genannten Art. Genannt seien auch Acrylsäure, Methacrylsäure sowie deren Derivate wie (Meth)acrylamid, N-Hydroxymethyl(meth)-acrylamid oder (Meth)acrylate von Monoalkoholen mit 1 bis 6 C-Atomen. Auch Mischungen der oben genannten niedermoleklarenn Verbindungen sind geeignet.

Ferner können Derivate von Acrylamiden, z.B. die Umsetzungsprodukte von 2 Mol N-Hydroxymethyl-(meth)acrylamid mit 1 Mol eines aliphatischen Diols, wie Ethylenglykol, Xylylenbisacrylamid oder Alkylenbisacrylamide mit 1 bis 8 C-Atomen im Alkylenrest mitverwendet werden. Für die herstellung wäßrig bzw. wäßrig-alkalisch entwickelbarer Aufzeichnungsmassen z.B. für die Herstellung von Druckplatten mit Polyvinylalkohol, Polyvinylalkohol-Alkoxylierungsprodukten, Polyvinylpyrrolidon oder Acrylatkautschuken mit seitenständigen Carboxylgruppen als polymeren Bindemitteln eignen sich besonders wasserlösliche Monomere, wie z.B. Hydroxyethyl(meth)acrylat oder Mono- und Di(meth)acrylate von Polyethylenglykolen mit einem Molekulargewicht von etwa 200 bis 500.

Als organische polymere Bindemittel b) für die Mischungen der wäßrigen oder wäßrig-alkalisch entwickelbaren photopolymerisierbaren Aufzeichnungsmassen und insbesondere für die Herstellung von Druckplatten und Reliefformen kommen die bekannten dafür verwendeten Polymeren in Frage, wobei sie mit den mitverwendeten niedermolekularen Verbindungen a) im allgemeinen verträglich und - für den Fachmann selbstverständlich - in dem verwendeten Entwickler löslich oder dispergierbar sein sollen, um ein Auswaschen der unbelichteten und unvernetzten Anteile einer Schicht der photopolymerisierbaren Aufzeichnungsmassen nach ihrer bildmäßigen Belichtung zu ermöglichen. Als geeignete gesättigte oder ungesättigte Bindemittel seien genannt Cellulosederivate, insbesondere wäßrig-alkalisch auswaschbare Cellulosederivate, Vinylalkohol-Polymere und Polymere und Copolymere von Vinylestern aliphatischer Monocarbonsäuren mit 1 bis 4 C-Atomen, wie Vinylacetat, mit unterschiedlichem Verseifungsgrad, Polyurethane, Polyetherurethane und Polyesterurethane. Von den durch Umsetzung von ungesättigten und gegebenenfalls gesättigten zwei- und gegebenenfalls mehrbasischen Carbonsäuren mit Di- und gegebenenfalls mehrbasischen Polyalkoholen hergestellten Polyestern linearer oder verzweigter Natur sind solche mit einer höheren Säurezahl und insbesondere einer Säurezahl zwischen 75 und 160 bevorzugt, da sie in den Massen zu

einer guten Dispergierbarkeit oder Löslichkeit in alkalisch-wäßrigen Entwicklerlösungsmitteln führen. Bezüglich der Zusammensetzung und Herstellung von carboxylgruppenhaltigen ungesättigten Polyesterharzen sei auf die vorhandene Literatur, z.B. das Buch von H.V. Boening, "Unsaturated Polyesters, Structure and Properties", Amsterdam, 1964, verwiesen.

Ferner eignen sich besonders vorteilhaft Acrylatkautschuke mit seitenständigen Carboxylgruppen, wie z.B. Ethylen/n-Butylacrylat/Acrylsäure-Copolymerisate, sowie die in den deutschen Patentanmeldungen DE-A-35 40 905, 35 43 646 und 36 02 472 näher beschriebenen Bindemittel.

Die erfindungsgemäßen Aufzeichnungsmassen bestehen überwiegend, d.h. zu mehr als 50 und bevorzugt zu 70 bis 100 Gew.% aus der Photoinitiator enthaltenden Mischung aus a) und b). Der Gehalt dieser Mischung an polymerem Bindemittel b) beträgt beispielsweise 45 bis 90 und insbesondere 45 bis 65 Gew.%, bezogen auf die Summe der Mengen an Polymeren b) und photopolymerisierbaren niedermolekularen Verbindungen a).

Es ist oft zwekcmäßig, den photopolymerisierbaren Massen in üblichen Mengen auch bekannte Inhibitoren gegen die thermische Polymerisation zuzusetzen, wie Hydrochinon, p-Methoxyphenol, m-Dinitrobenzol, p-Chinon, Methylenblau, β-Naphthol, N-Nitrosamine wie N-Nitrosodiphenylamin, Phenothiazin, Phosphorigsäureester wie Triphenylphosphit oder die Salze und insbesondere die Alkali- und Aluminiumsalze des N-Nitroso-cyclohexyl-hydroxylamins.

Die Massen können auch weitere übliche Zusätze enthalten, wie Weichmacher, gesättigte niedermolekulare Verbindungen mit Amidgruppen, und Wachse .

Die Verarbeitung der photopolymerisierbaren Aufzeichnungsmassen, z.B. zu Photopolymerdruckplatten, die schichtförmig die Aufzeichnungsmassen als reliefformmende Schicht aufweisen, kann in an sich bekannter Weise erfolgen und ist von der Art der Mischung a) + b) und davon abhängig, ob die Masse flüssig oder fest ist. Die Verarbeitung der Aufzeichnungsmassen (z.B. zu Reliefformen) erfolgt in bekannter Art durch bildmäßiges Belichten mit aktinischem Licht mit Lichtquellen, die Maxima der Emission im Bereich der Absorption der Photoinitiatoren, zweckmäßigerweise im Bereich von 300 bis 500 nm besitzen oder einen ausreichenden Anteil von Licht dieses Wellenlängenbereiches aufweisen, wie aktinische oder superaktinische Leuchtstoffröhren, Quecksilber-Nieder-, -Mittel- und -Hochdruckstrahler, die gegebenenfalls auch dotiert sein können, sowie Xenonlampen. Nach der bildmäßigen Belichtung werden für die Herstellung von Reliefformen oder Photoresists die nichtbelichteten Anteile der Schicht der Aufzeichnungsmassen in bekannter Art mit reinem Wasser bzw. wäßrigem Alkali, wie z.B. 1 %iger wärßiger Natronlauge ausgewaschen und die resultierenden Formen, z.B. Reliefdruckformen, getrocknet, in manchen Fällen zweckmäßigerweise noch voll nachbelichtet.

Die erfindungsgemäßen photopolymerisierbaren Aufzeichnungsmassen zeichnen sich durch eine hohe Reaktivität bei der Belichtung aus, die eine schnellere Aushärtung belichteter Schichtteile ermöglicht. Es ist überraschend, daß die Aufzeichnungsmassen dennoch eine hervorragende Stabilität bei ihrer Lagerung aufweisen. Von besonderem Vorteil ist, daß es mit den neuen Aufzeichnungsmassen möglich ist, die Vorbelichtungszeit genauer einzustellen und sogar die Gesamtbelichtungszeit erheblich zu verkürzen.

Die in den folgenden Beispielen und Vergleichsbeispielen genannten Teile und Prozente beziehen sich, soweit nicht anders angegeben, auf das Gewicht. Teile verhalten sich zu Volumenteile wie Kilogramm zu Liter.

Beispiel 1

Es wurde eine photopolymerisierbare Mischung aus 73 % eines Copolymerisats aus 57,8 % Ethylen, 24 % n-Butylacrylat und 18,2 % Acrylsäure (MFI-Wert = melt flow index: 250), 20 % Phthalsäuredi(2-ethylhexyl)ester, 5,5 % Butandioldiacrylat, 0,2 % t-Butylkresol und 1,3 % des Photoinitiators Bis[2,6-dichlorbenzoyl]phenylphosphinoxid als 48 %ige Lösung in einem 80 °C warmen Gemisch aus 50 % Toluol und 50 % Diethylenglykoldimethylether hergestellt. Diese Mischung wurde in einer solchen Naßschichtdicke auf ein mit Haftlack beschichtetes Stahlblech von 0,24 mm Dicke aufgetragen, daß nach dem Ablüften der Lösemittel und einer zweistündigen Trocknung der Schicht bei bei 85 °C eine Trockenschichtdicke von 0,380 mm resultierte.

Diese Schicht wurde auf übliche Weise durch ein Negativ, das alle druckrelevanten Elemente enthielt, mittels eines handelsüblichen 5 kW-Quecksilberdampfmitteldruckbrenners so lange belichtet, bis alle Reliefelemente nach dem Auswaschprozeß (mit ca. 1 %iger wäßriger Natronlauge) korrekt ausgebildet waren. Die hierfür erforderliche Mindestbelichtungszeit betrug 2,5 Minuten. Die Messung der Mikrohärte (gemessen in International Rubber Hardness Degree-Einheiten) ergab einen Wert von 83 I.R.H.D.

Ähnliche Ergenbisse erhält man, wenn man anstelle von Bis[2,6-dichlorbenzoyl]-phenylphosphinoxid

Bis[2,6-dimethoxybenzoyl]-phenylphosphinoxid einsetzt.

Vergleichsbeispiel 1

Es wurde wie in Beispiel 1 beschrieben verfahren, nur wurde anstelle des Bis[2,6-dichlorbenzoyl]-phenylphosphinoxids, 2,4,6-Trimethylbenzoyldiphenylphosphinoxid eingesetzt. Die erforderliche Mindestbelichtungszeit betrug 3,75 Minuten. Die Messung der Mikrohärte ergab einen Wert von 74 I.R.H.D.

Beispiel 2

500 Teile Wasser wurden auf 85 bis 90°C erhitzt. Bei dieser Temperatur wurden dann unter gleichmäßigem Rühren (200 Umdrehungen/Minute) nacheinander eingetragen: 347 Teile eines teilverseiften Polyvinylacetats mit einem mittleren Verseifungsgrad von 81 % und einem mittleren Molekulargewicht von etwa 25.000, 149 Teile eines mit Polyethylenoxidsegmenten in der Hauptkette innerlich weichgemachten Polyvinylalkohols mit einem mittleren Acetalisierungsgrad von 14 % und einem mittleren Molekulargewicht von etwa 22.000. Nach fünfstündigem Rühren wurde auf 60°C abgekühlt. Bei dieser Temperatur wurde ein Gemisch aus 420 Teilen β-Hydroxyethylmethacrylat und 6 Teilen Bis[2,6-dichlorbenzoyl]phenylphospinoxid eingetragen. Nach Homogenisiergung dieser Mischung wurde damit auf einer Stahlunterlage eine Trockenschicht von 0,5 mm Dicke erzeugt. Diese photopolymerisierbare Schicht erfordert unter praxisüblichen Bedingungen eine Mindestbelichtungszeit von 18 Sekunden zur Reproduktion aller druckrelevanten Reliefelemente. Die Härte der Schicht beträgt nach Belichtung mit einem 5 KW-Quecksilberbrenner, Entwicklung mit Wasser und Trocknung (15 Minuten/80°C) 2050 cN` $mm^{-2}$ (Kugeldruckhärte nach Brinell).

Vergleichsbeispiel 2

Es wurde wie in Beispiel 2 beschrieben verfahren, nur wurde anstelle von Bis[2,6-dichlorbenzoyl]-phenylphosphinoxid 2,4,6-Trimethylbenzoyldiphenylphosphinoxid eingesetzt. Die erforderliche Mindestbelichtungszeit betrug 26 Sekunden. Die Härte der Schicht betrug nach Belichtung, Entwicklung und Trocknung etwa 1650 cN` $mm^{-2}$.

Beispiel 3

294 Teile eines teilweise verseiften Polyvinylacetats (Verseifungsgrad 82 Mol.%, Durchschnittspolymerisationsgrad = 500) wurden durch mehrstündiges Rühren in 294 Teilen Wasser bei 90°C gelöst. Nach Abkühlen auf 70°C wurden unter Rühren 200 Teile eines Monomerengemisches aus 180 Teilen 2-Hydroxyethylmethacrylat und 20 Teilen 1,1,1-Trimethylolpropantriacrylat sowie 10 Teile Bis(2,6-dichlorbenzoyl)phenylphosphinoxid und 2 Teile 2,6-Di-tert.-butyl-p-kresol zugegeben. Die homogene, viskose Lösung wird filtriert und unter reduziertem Druck entgast. Durch Aufbringen auf ein mit einem Haftlack versehenen Stahlblech und 24-stündiges Trocknen bei Raumtemperatur wird eine 550 µm dicke nicht klebende Schicht der Aufzeichnungsmasse erhalten. Nach 3 Sekunden Vorbelichtung und nachfolgender Belichtung von 30 Sekunden durch ein Negativ in einem mit einem Fe-dotierten Hg-Mitteldruckbrenner (5 KW) versehenen Druckplattenbelichter und anschließendem Auswaschen mit Wasser in einem Sprühwascher sowie anschließendes Trocknen bei 100°C wird ein Klischee mit guter Reliefstruktur und hervorragenden mechanischen Eigenschaften erhalten, von dem mehrere Tausend Drucke ohne jeden Qualitätsabfall gedruckt wurden. Die Reliefdruckformen geben beim Drucktest gut ausgebildete lesbare Negativschriften, die den Ansprüchen bei Zeitungen voll genügen.

Vergleichsbeispiel 3

Wie in Beispiel 3 beschrieben wird eine Druckplatte mit einer Aufzeichnungsmasse hergestellt, die jedoch als Photoinitiator in gleicher Menge 2,4,6-Trimethylbenzoyldiphenylphosphinoxid enthält. Der Vergleich der notwendigen Belichtungszeit der Aufzeichnungsmassen bei jeweils gleichem Mengengehalt an dem jeweiligen Photoinitiator zeigte folgende Eigenschaften:

| Aufzeichnungsmasse enthaltend | Vorbelichtung | bildmäßige Belichtung |
|---|---|---|
| 2,4,6-Trimethylbenzoyldiphenylphosphinoxid (= Vergleichsbeispiel 3) | 2 s | 40 s |
| Bis(2,6-dichlorbenzoyl)phenylphosphinoxid (= Beispiel 3) | 3 s | 30 s |

## Ansprüche

1. Photopolymerisierbare Aufzeichnungsmasse, die wäßrig oder wäßrig-alkalisch entwickelbar ist, insbesondere für die Herstellung von Druckplatten und Reliefformen, überwiegend bestehend aus einer einen Photoinitiator enthaltenden Mischung von a) mindestens einer niedermolekularen Verbindung mit mindestens einer photopolymerisierbaren olefinisch ungesättigten Doppelbindung und b) mindestens einem organischen polymeren Bindemittel, dadurch gekennzeichnet, daß sie als Photoinitiator mindestens eine Bisacylphosphinoxid-Verbindung der Formel

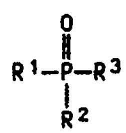

(I) ,

wobei

$R^1$ für einen alkylrest mit 1 bis 6 Kohlenstoffatomen, einen Cycloalkylrest mit 5 oder 6 Ringkohlenstoffatomen einen Alkoxyrest mit 1 bis 4 C-Atomen, einen gegebenenfalls halogen-, alkyl- oder alkoxy-substituierten Arylrest oder einen S- oder N-haltigen fünf- oder sechsgliedrigen heterocyclischen Rest steht;

$R^2$ und $R^3$ untereinander gleiche oder verschiedene Acylreste sind, an deren Carbonylgruppe ein tertiärer Alkylrest mit 4 bis 18 C-Atomen, ein tertiärer Cycloalkylrest mit 5 oder 6 Ringkohlenstoffatomen, ein Arylrest oder ein 5- oder 6-gliedriger heterocyclischer Rest gebunden ist, wobei die Aryl- oder 5- oder 6-gliedrigen heterocyclischen Reste mindestens in den beiden ortho-Stellungen zur Carbonylgruppierung Substituenten A und B gebunden enthalten, wobei A und B Alkyl-, Alkoxy-, Alkoxyalkyl-, Alkylthio-, Cycloalkyl- oder Arylreste oder Halogenatome sind und A und B gleich oder verschieden sein können,

und als organisches Bindemittel (b) mindestens ein wäßrig oder wäßrigalkalisch auswaschbares Bindemittel aus der Gruppe der Cellulosederivate, der Polymeren mit wiederkehrenden Vinylalkoholgruppen in der Molekülhauptkette, der Polyurethane, Polyetherurethane, Polyesterurethane, der Polyester linearer oder verzweigter Natur und der Acrylatkautschuke mit seitenständigen Carboxylgruppen enthält.

2. Photopolymerisierbare Aufzeichnungsmasse nach Anspruch 1, dadurch gekennzeichnet, daß in Formel (I) $R^1$ einen Alkoxyrest mit 1 bis 4 C-Atomen oder einen Arylrest mit 6 bis 12 C-Atomen darstellt.

3. Photopolymerisierbare Aufzeichnungsmasse nach Anspruch 1 oder 2, dadurch gekennzeichnet, daß in Formel (I) $R^2$ und $R^3$ Acylreste sind, an deren Carbonylgruppe ein tertiärer Alkylrest mit 4 bis 18 C-Atomen oder ein tertiärer Cycloalkylrest mit 5 oder 6 Ringkohlenstoffatomen gebunden ist.

4. Photopolymerisierbare Aufzeichnungsmasse nach Anspruch 1 oder 2, dadurch gekennzeichnet, daß in Formel (I) die Reste $R^2$ und $R^3$ gleich sind und mindestens in 2,6-Stellung mit Gruppen A und B substituierte Benzoylreste darstellen.

5. Photopolymerisierbare Aufzeichnungsmasse nach einem der Ansprüche 1 bis 4, dadurch gekennzeichnet, daß sie ein tertiäres Amin enthält.

6. Verfahren zur Herstellung von Reliefformen durch bildmäßiges Belichten von auf einen Träger aufgebrachten Schichten einer photopolymerisierbaren Aufzeichnungsmasse und nachfolgendes Entfernen der unbelichteten Schichtanteile der photopolymerisierbaren Aufzeichnungsmasse, dadurch gekennzeichnet, daß eine photopolymerisierbare Aufzeichnungsmasse gemäß einem der Ansprüche 1 bis 5 verwendet wird.

Patentansprüche für folgenden vertragsstaat: ES

1. Verfahren zur Herstellung einer photopolymerisierbaren Aufzeichnungsmasse, die wäßrig oder wäßrigalkalisch entwickelbar ist, insbesondere für die Herstellung von Druckplatten und Reliefformen, überwiegend bestehend aus einer Photoinitiator enthaltenden Mischung von a) mindestens einer niedermolekularen Verbindung mit mindestens einer photopolymerisierbaren olefinisch ungesättigten Doppelbindung und b) mindestens einem organischen polymeren Bindemittel, dadurch gekennzeichnet, daß als Photoinitiator mindestens eine Bisacylphosphinoxid-Verbindung der Formel

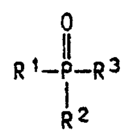

(I),

wobei

$R^1$ für einen Alkylrest mit 1 bis 6 Kohlenstoffatomen, einen Cycloalkylrest mit 5 oder 6 Ringkohlenstoffatomen, einen Alkoxyrest mit 1 bis 4 C-Atomen, einen gegebenenfalls halogen-, alkyl- oder alkoxy-substituierten Arylrest oder einen S- oder N-haltigen fünf- oder sechsgliedrigen heterocyclischen Rest steht;

$R^2$ und $R^3$ untereinander gleiche oder verschiedene Acylreste sind, an deren Carbonylgruppe ein tertiärer Alkylrest mit 4 bis 18 C-Atomen, ein tertiärer Cycloalkylrest mit 5 oder 6 Ringkohlenstoffatomen, ein Arylrest, oder ein 5- oder 6-gliedriger heterocyclischer Rest gebunden ist, wobei die Aryl- oder 5- oder 6-gliedrigen heterocyclischen Reste mindestens in den beiden ortho-Stellungen zur Carbonylgruppierung Substituenten A und B gebunden enthalten, wobei A und B Alkyl-, Alkoxy-, Alkoxyalkyl-, Alkylthio-, Cycloalkyl- oder Arylreste oder Halogenatome sind und A und B gleich oder verschieden sein können,

und als organisches Bindemittel (b) mindestens ein wäßrig oder wäßrigalkalisch auswaschbares Bindemittel aus der Gruppe der Cellulosederivate, der Polymeren mit wiederkehrenden Vinylalkoholgruppen in der Molekülhauptkette, der Polyurethane, Polyetherurethane, Polyesterurethane, der Polyester linearer oder verzweigter Natur und der Acrylatkautschuke mit seitenständigen Carboxylgruppen eingesetzt wird.

2. Verfahren nach Anspruch 1, dadurch gekennzeichnet, daß eine Bisacylphosphinoxid-Verbindung der Formel (I) eingesetzt wird, worin $R^1$ einen Alkoxyrest mit 1 bis 4 C-Atomen oder einen Arylrest mit 6 bis 12 C-Atomen darstellt.

3. Verfahren nach Anspruch 1 oder 2, dadurch gekennzeichnet, daß als Photoinitiator eine Bisacylphosphinoxid-Verbindung der Formel (I) eingesetzt wird, worin $R^2$ und $R^3$ Acylreste sind, an deren Carbonylgruppe ein tertiärer Alkylrest mit 4 bis 18 C-Atomen oder ein tertiärer Cycloalkylrest mit 5 oder 6 Ringkohlenstoffatomen gebunden ist.

4. Verfahren nach Anspruch 1 oder 2, dadurch gekennzeichnet, daß eine Bisacylphosphinoxid-Verbindung der Formel (I) eingesetzt wird, in der die Reste $R^2$ und $R^3$ gleich sind und mindestens in 2,6-Stellung mit Gruppen A und B substituierte Benzoylreste darstellen.

5. Verfahren nach einem der Ansprüche 1 bis 4, dadurch gekennzeichnet, daß zusätzlich ein tertiäres Amin mitverwendet wird.

6. Verfahren zur Herstellung von Reliefformen durch bildmäßiges Belichten von auf einen Träger aufgebrachten Schichten einer photopolymerisierbaren Aufzeichnungsmasse, und nachfolgendes Entfernen der unbelichteten Schichtanteile der photopolymerisierbaren Aufzeichnungsmasse, dadurch gekennzeichnet, daß eine photopolymerisierbare Aufzeichnungsmasse, die nach einem Verfahren gemäß einem

der Ansprüche 1 bis 5 erhalten worden ist, verwendet wird.

**Claims**

1. A photopolymerizable recording material which can be developed with water or an aqueous alkaline solution, in particular for the production of printing plates and relief plates, predominantly consisting of a photoinitiator-containing mixture of (a) one or more low molecular weight compounds having one or more photopolymerizable olefinically unsaturated double bonds and (b) one or more organic polymeric binders, wherein the said recording material contains, as a photoinitiator, one or more bisacylphosphine oxide compounds of the formula

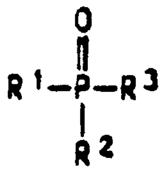

(I)

where $R^1$ is alkyl of 1 to 6 carbon atoms, cycloalkyl where the ring is of 5 or 6 carbon atoms,alkoxy of 1 to 4 carbon atoms, aryl which is unsubstituted or substituted by halogen, alkyl or alkoxy, or an S-containing or N-containing five-membered or six-membered heterocyclic radical, and $R^2$ and $R^3$ are identical or different acyl radicals whose carbonyl group is bonded to a tertiary alkyl radical of 4 to 18 carbon atoms, a tertiary cycloalkyl radical where the ring is of 5 or 6 carbon atoms, aryl or a 5-membered or 6-membered heterocyclic radical, and the aryl or 5-membered or 6-membered heterocyclic radicals contain substituents A and B bonded at least in the two positions ortho to the carbonyl group, and A and B may be identical or different and are each alkyl, alkoxy, alkoxyalkyl, alkylthio, cycloalkyl, aryl or halogen, and, as an organic binder b), one or more binders which can be washed out with aqueous or aqueous alkaline media and are selected from the group consisting of the cellulose derivatives, the polymers having repeating vinyl alcohol groups in the main chain of the molecule, the polyurethanes, polyetherurethanes, polyesterurethanes, the straight-chain or branched polyesters and the acrylate rubbers having carboyl side groups.

2. A photopolymerizable recording material as claimed in claim 1 or 2, wherein in formula (I) $R^1$ is alkoxy of 1 to 4 carbon atoms or aryl of 6 to 12 carbon atoms.

3. A photopolymerizable recording material as claimed in claim 1 or 2, wherein in formula (I) $R^2$ and $R^3$ are each acyl whose carbonyl group is bonded to a tertiary alkyl radical of 4 to 18 carbon atoms or tertiary cycloalkyl radical where the ring is of 5 or 6 carbon atoms.

4. A process as claimed in claim 1 or 2, wherein a bisocylphosphine oxide compound of the formula (I) is employed, in which $R^2$ and $R^3$ are identical and are each a benzoyl radical which is substituted by groups A and B at least in the 2,6-position.

5. A process as claimed in claim 1 or 2 or 3 or 4, additionally in the presence of a tertiary amine.

6. A process for the production of relief plates by imagewise exposure of a layer which is applied to a base and consists of a photopolymerizable recording material and subsequent removal of the unexposed parts of the layer of the photopolymerizable recording material, wherein a photopolymerizable recording material which has been obtained by a process as claimed in claim 1 or 2, or 3 or 4 or 5 is used.

Claims for the Contracting State: ES

1. A process for the preparation of a photopolymerizable recording material which can be developed with water or an aqueous alkaline solution, in particular for the production of printing plates and relief plates, predominantly consisting of a photoinitiator-containing mixture of (a) one or more low molecular weight compounds having one or more photopolymerizable olefinically unsaturated double bonds and (b) one or more organic polymeric binders, wherein one or more bisacylphosphine oxide compounds of the

formula

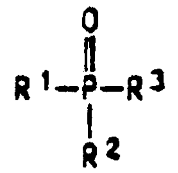

(I)

where $R^1$ is alkyl of 1 to 6 carbon atoms, cycloalkyl where the ring is of 5 or 6 carbon atoms, alkoxy of 1 to 4 carbon atoms, aryl which is unsubstituted or substituted by halogen, alkyl or alkoxy, or an S-containing or N-containing five-membered or six-membered heterocyclic radical, and $R^2$ and $R^3$ are identical or different acyl radicals whose carbonyl group is bonded to a tertiary alkyl radical of 4 to 18 carbon atoms, a tertiary cycloalkyl radical where the ring is of 5 or 6 carbon atoms, aryl or a 5-membered or 6-membered heterocyclic radical, and the aryl or 5-membered or 6-membered heterocyclic radicals contain substituents A and B bonded at least in the two positions ortho to the carbonyl group, and A and B may be identical or different and are each alkyl, alkoxy, alkoxyalkyl, alkylthio, cycloalkyl, aryl or halogen, are used as the photoinitiator and one or more binders which can be washed out with aqueous or aqueous alkaline media and are selected from the group consisting of the cellulose derivatives, the polymers having repeating vinyl alcohol groups in the main chain of the molecule, the polyurethenes, the polyetherurethanes, the polyesterurethanes, the straight-chain or branched polyesters and the acrylate rubbers having carboxyl side groups are used as the organic binder (b).

2. A process as claimed in claim 1, wherein a bisacylphosphine oxide compounds of the formula (I) is employed, where $R^1$ is alkoxy of 1 to 4 carbon atoms or aryl of 6 to 12 carbon atoms.

3. A process wherein as claimed in claim 1 or 2, a bisacylphosphine oxide compound of the formula (I) is employed as photoinitiator in which compound $R^2$ and $R^3$ are each acyl whose carbonyl group is bonded to a tertiary alkyl radical of 4 to 18 carbon atoms or tertiary cycloalkyl radical where the ring is of 5 or 6 carbon atoms.

4. A process as claimed in claim 1 or 2, wherein in formula (I) $R^2$ and $R^3$ are identical and are each a benzoyl radical which is substituted by groups A and B at least in the 2,6-position.

5. A photopolymerizable recording material as claimed in claim 1 or 2 or 3 or 4, which contains a tertiary amine.

6. A process for the production of relief plates by imagewise exposure of a layer which is applied to a base and consists of a photopolymerizable recording material and subsequent removal of the unexposed parts of the layer of the photopolymerizable recording material, wherein a photopolymerizable recording material as claimed in claim 1 or 2 or 3 or 4 or 5 is used.

## Revendications

1. Masse d'enregistrement photopolymérisable pouvant être développée en milieu aqueux ou aqueux alcalin, convenant en particulier pour la fabrication de plaques d'impression et de formes en relief, consistant principalement en un mélange, qui contient un photoinducteur, de a) au moins un composé à bas poids moléculaire contenant au moins une double liaison insaturée oléfinique photopolymérisable, et b) au moins un liant organique polymère, caractérisée en ce qu'elle contient en tant que photoinducteur au moins un oxyde de bis-acylphosphine de formule

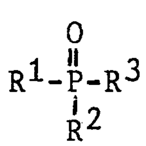

(I),

dans laquelle

$R^1$ représente un groupe alkyle en C1-C6, un groupe cycloalkyle en C5 ou C6, un groupe alcoxy en C1-C4, un groupe aryle éventuellement substitué par des halogènes, des groupes alkyle ou alcoxy, ou un radical hétérocyclique à 5 ou 6 chaînons contenant du soufre ou de l'azote;

$R^2$ et $R^3$, ayant des significations identiques ou différentes, représentent des radicaux acyle portant, fixé sur leur groupe carbonyle, un groupe tert-alkyle en C4-C18, un groupe tert-cycloalkyle à 5 ou 6 atomes de carbone cycliques, un groupe aryle ou un radical hétérocyclique à 5 ou 6 chaînons, les radicaux aryle ou les radicaux hétérocycliques à 5 ou 6 chaînons portant, au moins dans les deux positions ortho du groupement carbonyle, des substituants A et B, identiques ou différents, qui consistent en groupes alkyle, alcoxy, alcoxyalkyle, alkylthio, cycloalkyle, aryle ou en atomes d'halogènes,

et en tant que liant organique b) au moins un liant, extractible en milieu aqueux ou aqueux-alcalin, du groupe des dérivés de la cellulose, des polymères contenant des groupes alcool vinylique répétés dans la chaîne principale de la molécule, des polyuréthannes, des polyéther-uréthannes, des polyester-uréthannes, des polyesters de nature linéaire ou ramifiée et des caoutchoucs d'acrylates à groupes carboxyle latéraux.

2. Masse d'enregistrement photopolymérisable selon la revendication 1, caractérisée en ce que, dans la formule I, $R^1$ représente un groupe alcoxy en C1-C4 ou un groupe aryle en C6-C12.

3. Masse d'enregistrement photopolymérisable selon la revendication 1 ou 2, caractérisée en ce que, dans la formule I, $R^2$ et $R^3$ représentent des radicaux acyle portant, sur leur groupe carbonyle, un groupe tert-alkyle en C4-C18 ou un groupe tert-cycloalkyle contenant 5 ou 6 atomes de carbone cycliques.

4. Masse d'enregistrement photopolymérisable selon la revendication 1 ou 2, caractérisée en ce que, dans la formule I, les radicaux $R^2$ et $R^3$ sont identiques et consistent en radicaux benzoyle substitués, au moins en position 2,6, par les groupes A et B.

5. Masse d'enregistrement photopolymérisable selon l'une des revendications 1 à 4, caractérisée en ce qu'elle contient une amine tertiaire.

6. Procédé pour la fabrication de formes en relief par exposition à la lumière avec formation d'une image de couches, appliquées sur un support, d'une masse d'enregistrement photopolymérisable et élimination subséquente des parties des couches non éclairées de la masse d'enregistrement photopolymérisable, caractérisé en ce que l'on utilise une masse d'enregistrement photopolymérisable selon l'une des revendications 1 à 5.

Revendications pour l'Etat contractant suivant: ES

1. Procédé de préparation d'une masse d'enregistrement photopolymérisable pouvant être développée en milieu aqueux ou aqueux alcalin, en particulier pour la fabrication de plaques d'impression et de formes en relief, consistant principalement en un mélange, contenant un photo-inducteur, de a) au moins un composé à bas poids moléculaire contenant au moins une double liaison à insaturation oléfinique photopolymérisable et b) au moins un liant organique polymère, caractérisé en ce que l'on utilise en tant que photo-inducteur au moins un oxyde de bis-acylphosphine de formule

$$R^1-\underset{R^2}{\underset{|}{\overset{\overset{O}{\|}}{P}}}-R^3 \qquad (I),$$

dans laquelle

$R^1$ représente un groupe alkyle en C1-C6, un groupe cycloalkyle à 5 ou 6 atomes de carbone cycliques, un groupe alcoxy en C1-C4, un groupe aryle éventuellement substitué par des halogènes, des groupes alkyle ou alcoxy, ou un groupe hétérocyclique à 5 ou 6 chaînons contenant du soufre ou de l'azote;

$R^2$ et $R^3$, ayant des significations identiques ou différentes, représentent des radicaux acyle portant, sur leur groupe carbonyle, un groupe tert-alkyle en C4-C18, un groupe tert-cycloalkyle à 5 ou 6 atomes de carbone cycliques, un groupe aryle ou un groupe hétérocyclique à 5 ou 6 chaînons, les groupes aryle et les groupes hétérocyclique à 5 ou 6 chaînons portant, au moins dans les deux positions ortho du groupement carbonyle, des substituants A et B, identiques ou différents, qui consistent en groupes alkyle, alcoxy, alcoxyalkyle, alkylthio, cycloalkyle ou aryle ou en atomes d'halogènes, et en tant que liant organique b), au moins un liant extractible en milieu aqueux ou aqueux alcalin, du groupe des dérivés de la cellulose, des polymères à groupes alcool vinylique répétés dans la chaîne principale de la molécule, des polyuréthannes, des polyéther-uréthannes, des polyester-uréthannes, des polyesters de nature linéaire ou ramifiée et des caoutchoucs d'acrylates à groupes carbonyle latéraux.

2. Procédé selon la revendication 1, caractérisé en ce que l'on utilise un oxyde de bis-acylphosphine de formule I dans laquelle $R^1$ représente un groupe alcoxy en C1-C4 ou un groupe aryle en C6-C12.

3. Procédé selon la revendication 1 ou 2, caractérisé en ce que l'on utilise en tant que photo-inducteur un oxyde de bis-acylphosphine de formule I dans laquelle $R^2$ et $R^3$ sont des groupes acyle portant, sur leur groupe carbonyle, un groupe tert-alkyle en C4-C18 ou un groupe tert-cycloalkyle à 5 ou 6 atomes de carbone cycliques.

4. Procédé selon la revendication 1 ou 2, caractérisé en ce que l'on utilise un oxyde de bis-acylphosphine de formule I dans laquelle les groupes $R^2$ et $R^3$ sont identiques et consistent en groupes benzoyle substitués, au moins en position 2,6, par les groupes A et B.

5. Procédé selon l'une des revendications 1 à 4, caractérisé en ce que l'on utilise en outre une amine tertiaire.

6. Procédé pour la fabrication de formes en relief par exposition à la lumière avec formation d'une image de couches, appliquées sur un support, d'une masse d'enregistrement photopolymérisable et élimination subséquente des parties des couches non éclairées de la masse d'enregistrement photopolymérisable, caractérisé en ce que l'on utilise une masse d'enregistrement photopolymérisable obtenue par un procédé selon l'une des revendications 1 à 5.